# EUROPÄISCHE PATENTSCHRIFT

(11) **EP 2 718 394 B1**
(45) Veröffentlichungstag und Bekanntmachung des Hinweises auf die Patenterteilung: **26.08.2015**
(21) Anmeldenummer: 10719329.4
(22) Anmeldetag: 05.05.2010
(51) Int. Cl.: C09K 11/06, C07F 15/00, H01L 51/50

(54) **PHOSPHORESZENTE METALLKOMPLEXVERBINDUNG, VERFAHREN ZUR HERSTELLUNG DAZU UND STRAHLUNGSEMITTIERENDES BAUELEMENT**
PHOSPHORESCENT METAL COMPLEX COMPOUND, METHOD FOR THE PRODUCTION THEREOF AND RADIATION EMITTING STRUCTURAL ELEMENT
COMPOSÉ COMPLEXE MÉTALLIQUE PHOSPHORESCENT, PROCÉDÉ DE FABRICATION ASSOCIÉ ET COMPOSANT ÉMETTEUR DE RAYONNEMENT

(30) Priorität: 03.07.2009 DE 102009031683
(43) Veröffentlichungstag der Anmeldung: 16.04.2014
(73) Patentinhaber: OSRAM GmbH, 80807 München (DE)
(72) Erfinder: DE COLA, Luisa, 48147 Münster (DE); YANG, Cheng-Han, 48161 Münster (DE); HARTMANN, David, 91056 Erlangen (DE); HERDER, Sabine, 91462 Dachsbach (DE); SARFERT, Wiebke, 91074 Herzogenaurach (DE); SCHMID, Günter, 91334 Hemhofen (DE)
(74) Vertreter: Epping - Hermann - Fischer
(86) Internationale Anmeldenummer: PCT/EP2010/056111
(87) Internationale Veröffentlichungsnummer: WO 2011/000616

(56) Entgegenhaltungen:
- WO-A1-2008/000727
- US-A1- 2007 108 891
- US-A1- 2009 079 329

## Beschreibung

Die Erfindung betrifft eine lichtemittierende organische elektrochemische Zelle (organic light emitting electrochemical cell OLEEC).

Im Gegensatz zu den weithin bekannten und bereits vielfach diskutierten OLEDs zeichnen sich die OLEECs vor allem durch einen wesentlich einfacheren Aufbau aus, da hier meist eine organische aktive Schicht benötigt wird, die über nasschemische Methoden aufbringbar ist.

In den organischen Licht emittierenden Dioden (OLEDs) wird, insbesondere bei den mit so genannten small molecules aufgebauten OLEDs, ein so genannter Multilayer-Aufbau realisiert, weil zusätzlich zu der Licht emittierenden Schicht auch noch effizienzerhöhende Schichten wie Loch- und/oder Elektroneninjektionsschichten zwischen den Elektroden zum besseren Übergang der Ladungsträger angeordnet werden. Oftmals werden dabei hochreaktive Materialien eingesetzt, so dass für die Lebensdauer des licht emittierenden Elements unter anderem die Verkapselung eine entscheidende Rolle spielt, da sie die Hilfsschichten vor Zersetzung bewahrt.

Da bei den OLEECs auf die reaktiven Elektroden der OLED verzichtet werden kann, ist die gesamte Verkapselungsproblematik bei den OLEECs nicht so schwierig wie bei den OLEDs. Die OLEECs gelten daher als zukunftsträchtiger Ersatz für die OLEDs.

Ganz generell haben organische elektrolumineszente Elemente zumindest eine organische Schicht, die sich zwischen zwei Elektroden befindet. Sobald Spannung an die Elektroden angelegt wird, werden Elektronen von der Kathode in die untersten unbesetzten Molekülorbitale der organischen Licht emittierenden Schicht injiziert und wandern auf die Anode zu. Korrespondierend dazu werden Löcher von der Anode in die obersten besetzten Molekülorbitale der organischen Schicht injiziert und wandern entsprechend zur Kathode. In den Fällen, wo sich wanderndes Loch und wanderndes Elektron innerhalb der organischen Licht emittierenden Schicht auf einem lichtemittierenden Stoff treffen, entsteht ein Exciton, das unter Lichtemission zerfällt. Damit das Licht überhaupt aus dem elektrolumineszierenden Element austreten kann, muss zumindest eine Elektrode transparent sein, in den meisten Fällen ist das eine Elektrode aus Indium-Zinn-Oxid, die als Anode eingesetzt wird. Die ITO-Schicht wird normalerweise auf einem Glasträger abgeschieden.

Es gibt jedoch noch keine ausreichende Auswahl an geeigneten Materialien für die emittierenden Schichten, insbesondere fehlt es an blau/grün emittierenden Materialien.

US 2009/079329 A1 beschreibt eine organische elektrolumineszierende Vorrichtung, welche zwei Elektroden und zumindest eine organische Schicht zwischen den beiden Elektroden umfasst, wobei die zumindest eine organische Schicht eine spezifische Verbindung enthält, in der ein Übergangsmetall und ein Carbenkohlenstoff miteinander eine Bindung eingehen.

WO 2008/000727 A1 erörtert die Verwendung von Übergangsmetallcarbenkomplexen in organischen Leuchtdioden. Bei den Übergangsmetallcarbenkomplexen erfolgt dabei die Verknüpfung der oder des Carbenliganden mit dem Übergangsmetall ausschließlich über Carbenkohlenstoffatome.

US 2007/108891 A1 stellt eine Metallkomplexverbindung und eine organische elektrolumineszierende Vorrichtung vor, in welcher besagte Metallkomplexverbindung zum Einsatz kommt. Insbesondere wird eine elektrolumineszierende Vorrichtung beschrieben, die eine hohe Effizienz der Lichtemission und eine hohe Haltbarkeit aufweist.

Aufgabe der vorliegenden Erfindung ist es daher, eine Materialklasse zu schaffen, die für den Einsatz als iTMC in OLEEC-Zellen geeignet ist, sowie ein Beispiel für die Verwendung des Materials in einer OLEEC-Zelle anzugeben.

Der Gegenstand der Erfindung und die Lösung der Aufgabe werden durch die Ansprüche, die Beschreibung, und die Figuren offenbart.

Entsprechend ist Gegenstand der Erfindung eine lichtemittierende organische elektrochemische Zelleumfassend -ein Substrat, eine erste Elektrodenschicht auf dem Substrat, zumindest eine organische emittierende Schicht auf der ersten Elektrodenschicht und eine zweite Elektrodenschicht auf der organischen emittierenden Schicht, wobei die organische emittierende Schicht aus einer Matrix, die ein Isolator oder ein Ionenleiter mit Elektrolyt-Eigenschaften ist und einer phosphoreszenten Metallkomplexverbindung besteht, wobei die Metallkomplexverbindung zumindest ein metallisches Zentralatom M und zumindest einen durch das metallisches Zentralatom koordinierten Liganden umfasst, wobei der eine Ligand zweizähnig ist, zwei neutralen Koordinationsstellen hat und zumindest eine Carbeneinheit, die direkt an das Metallatom koordiniert ist, umfasst, wobei die Verbindung zumindest eine der Strukturformeln 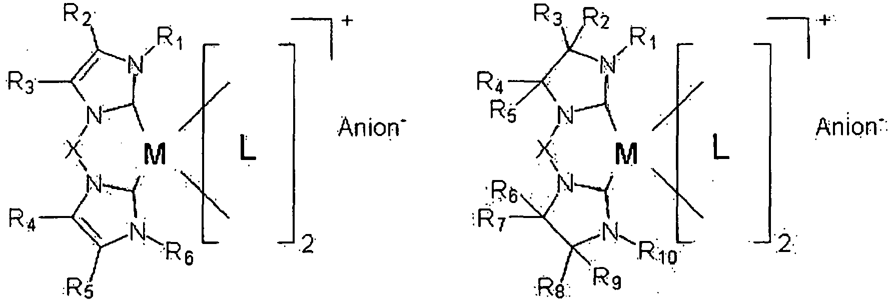 aufweist, wobei gilt:
- M = Ir, Re, Os, Au, Hg, Ru, Rh, Pd, Ag, Cu
- R₁ bis R₁₀ sind unabhängig voneinander - H, verzweigte Alkylreste, unverzweigte Alkylreste, kondensierte Alkylreste, ringförmige Alkylreste, vollständig oder teilweise substituierte unverzweigte Alkylreste, vollständig oder teilweise substituierte verzweigte Alkylreste, vollständig oder teilweise substituierte kondensierte Alkylreste, vollständig oder teilweise substituierte ringförmige Alkylreste, Alkoxygruppen, Amine, Amide, Ester, Carbonate, Aromaten, vollständig oder teilweise substituierte Aromaten, Heteroaromaten, kondensierte Aromaten, vollständig oder teilweise substituierte kondensierte Aromaten, Heterocyclen, vollständig oder teilweise substituierte Heterocyclen, kondensierte Heterocyclen, Halogene, Pseudohalogene,
- X ist (-CR_{b1}R_{b2}-)ₙ, (-SiR_{b1}R_{b2}-)ₙ, -N-R_{b1}, P-R_{b1} oder 0, S, Se, wobei n im Bereich 0 - 10 liegt, wobei R_{b1} und R_{b2} analog R₁ bis R₁₀ ausgewählt sind,
- L ist über eine N^C Einheit an das Zentralatom M gebunden und ausgewählt aus einer Gruppe, die 2-Phenylpyridin, 2-Phenylimidazol, Benzimidazol, Phenanthridin und 2-(2,4-Difluorophenyl)pyridin umfasst und wobei
   R₁ und/oder R₆ zusätzlich an M koordiniert sind.

Eine Herstellung der genannten phosphoreszenten Metallkomplexverbindung ist über ein Verfahren mit den folgenden Verfahrensschritten möglich:
A) Bereitstellen einer metallorganischen Komplexverbindung mit einem metallischen Zentralatom, aufweisend an das Zentralatom koordinierte Austauschliganden, also Liganden, die leicht abgehen und damit gut ausgetauscht werden können,
B) mischen der Zentralatomverbindung und eines in einem ersten Lösungsmittel gelösten neutralen Liganden mit einer Carbeneinheit zur Bildung der Metallkomplexverbindung, wobei der Austauschligand durch den Liganden, der zweizähnig am Zentralatom koordiniert und eine Carbeneinheit umfasst, ersetzt wird.

Die beanspruchte lichtemittierende organische elektrochemische Zelle umfasst eine phosphoreszente Metallkomplexverbindung angehörend der nicht beanspruchten allgemeinen Materialklasse der folgenden allgemeinen Struktur I:

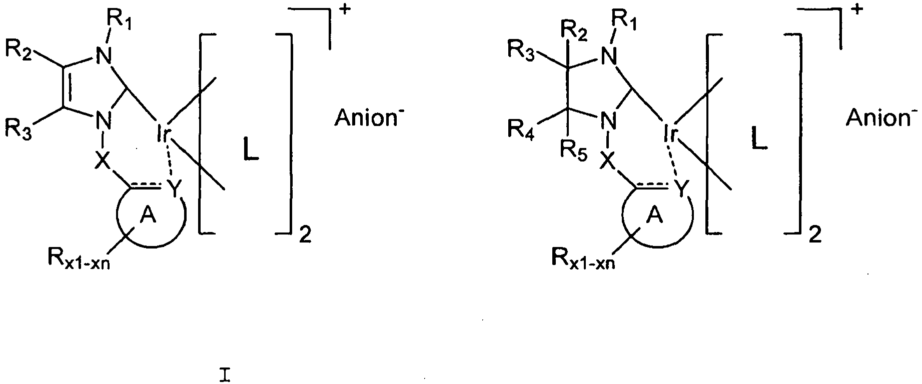

Struktur I: Die beiden zusätzlichen Liganden L, symbolisiert durch die rechteckige Klammer, werden aus den klassischen zyklometallisierenden Liganden ausgewählt, wie sie beispielsweise in WO2005097942A1 WO2006013738A1, WO2006098120A1, WO2006008976A1, WO2005097943A1, (Konica Minolta) oder, US 6,902,830, US 7,001,536, US 6,830,828 (UDC) beschrieben werden. Sie sind alle über eine N^C- Einheit an Iridium gebunden. Beispiel: 2-Phenylpyridin oder 2-Phenylimidazol und verwandte Strukturen, wie beispielsweise Benzimidazol oder Phenanthridin. Besonders die 2-Phenylimidazol-Abkömmlinge sind bekannt für eine Verschiebung der Emission in den blaugrünen bis blauen Spektralbereich.

Nach weiteren vorteilhaften Ausführungsformen können die beiden bekannten Liganden L beispielsweise über eine weitere Carbenfunktionalität verfügen, die als Quelle tiefer blauer Emission dient. Beispiele für diese Liganden L sind in den Veröffentlichungen WO200519373 oder EP1692244B1 zu finden.

Weitere Beispiele möglicher Liganden L sind aus den Veröffentlichungen EP1904508A2, WO2007004113A2, WO2007004113R4A3 bekannt, wobei diese Liganden L auch im Rahmen von geladenen Metallkomplexen, die zumindest einen Phenylpyridin Ligand mit entsprechenden Donorgruppen wie Dimethylamino haben, gezeigt werden. Diese Verbindungen zeigen ein erhöhtes LUMO Niveau des Komplexes, wobei Akzeptorgruppen wie beispielsweise 2,4 Difluoro, in den Phenylring eingeführt werden, um das Niveau des HOMO-Orbitals zu erniedrigen. Es wird gezeigt, dass man durch die Variation der Liganden und deren Substituenten die Emissionsfarbe durch das ganze sichtbare Spektrum hindurch variieren kann.

Der Metallkomplex gemäß der Strukturformel I hat zusätzlich zu den zwei Liganden L einen Liganden, der bevorzugt zweizähnig und neutral ist und mindestens einen Carbenliganden enthält. Somit entsteht eine Struktur der allgemeinen Formel I.

Nach einer Ausführungsform der Materialklasse sind die beiden durch die Klammer symbolisierten und bereits in der Literatur bekannten Liganden L vorzugsweise cyclometallisierende Liganden, ausgewählt aus den folgenden Dokumenten: WO2005097942A1, WO2006013738A1, WO2006098120A1, WO2006008976A1, WO2005097943A1, WO2006008976A1 (Konica Minolta) oder, US 6,902,830, US 7,001,536, US 6,830,828, WO2007095118A2, US20070190359A1 (UDC), EP1486552B1.

Generell sind alle Reste R = unabhängig voneinander- H, verzweigte Alkylreste, unverzweigte Alkylreste, kondensierte Alkylreste, ringförmige Alkylreste, vollständig oder teilweise substituierte unverzweigte, verzweigte, kondensierte und/oder ringförmige Alkylreste, Alkoxygruppen, Amine, Amide, Ester, Carbonate, Aromaten, vollständig oder teilweise substituierte Aromaten, Heteroaromaten, kondensierte Aromaten, vollständig oder teilweise substituierte kondensierte Aromaten, Heterocyclen, vollständig oder teilweise substituierte Heterocyclen, kondensierte Heterocyclen, Halogene, Pseudohalogene.

Alle Substituenten R₁, R₂, R₃ können unabhängig voneinander ausgewählt sein aus der oben genannten Resten, es handelt sich bevorzugt um C1 bis C20, kondensierte z.B. decahydronaphtyl-, adamantyl-, cyclischer, cyclohexyl-, oder voll oder teilweise substituierter Alkylrest, bevorzugt C1 bis C20. Diese Ketten oder Gruppen können verschiedene Endgruppen tragen, beispielsweise geladene Endgruppen wie SOₓ⁻, NR⁺ und so weiter.

Die Alkylreste können wiederum Gruppen wie Ether, Ethoxy-, Methoxy-, etc. Ester-, Amid-, Carbonat-, etc. oder Halogene, bevorzugt Fluor, tragen. R₁, R₂ und R₃ sollen aber nicht auf Alkylreste beschränkt sein, sondern kann ebenso gut substituierte oder unsubstituierte aromatische Systeme umfassen, wie beispielsweise Phenyl-, Biphenyl-, Naphtyl-, Phenanthryl-, Benzyl-, und so weiter. Eine Zusammenstellung der wichtigsten Vertreter ist in der folgenden Tabelle 1 zu sehen.

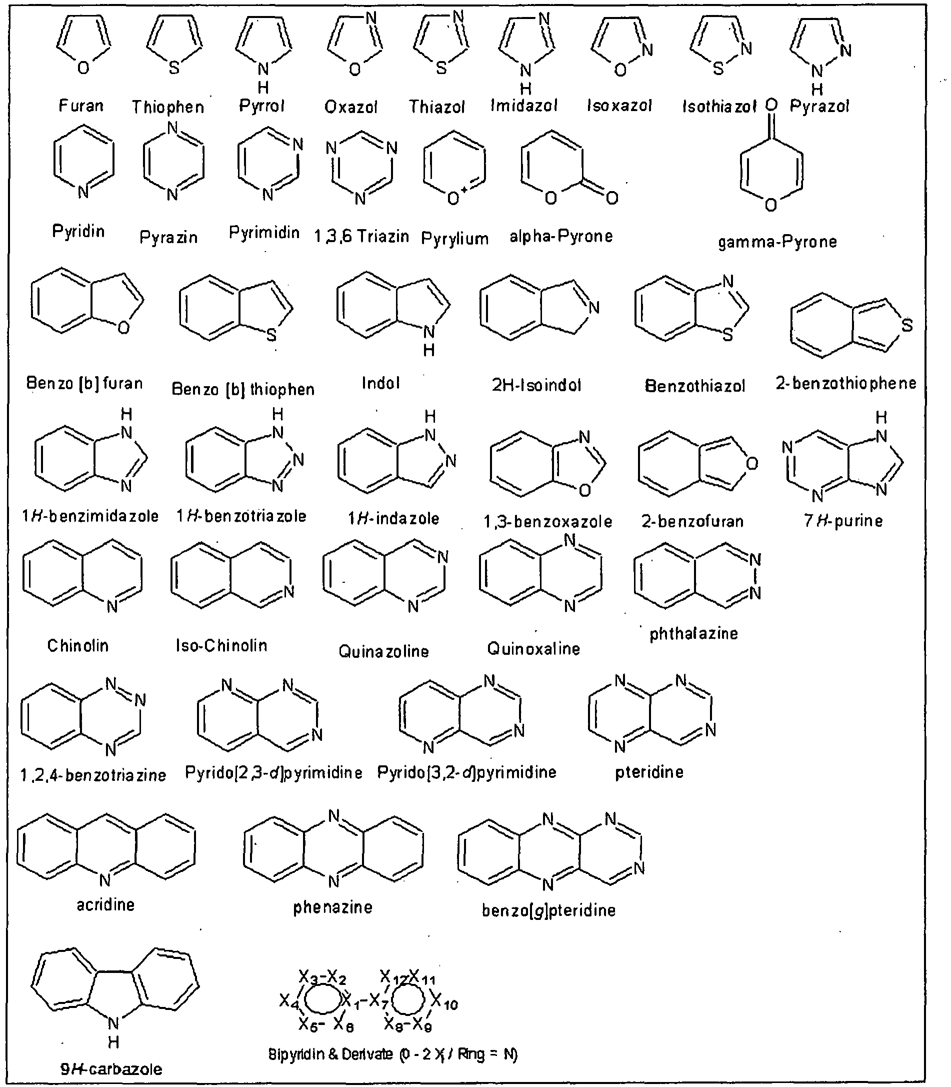

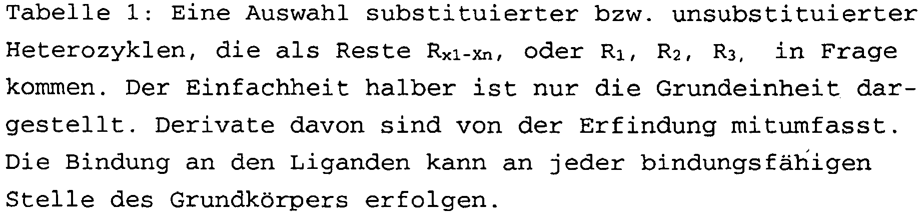

R₁, R₂ und R₃ können unabhängig voneinander auch jeweils miteinander verbrückt sein. Beispielsweise entstehen Benzimidazol-Derivate, wenn R₂ und R₃ in Struktur I verbrückt sind und einen Aromaten bilden. Der Benzimidazol-Grundkörper, der die Carbeneinheit bildet, kann wie oben erwähnt, ebenfalls substituiert sein.

Bevorzugte Varianten der Brücke X sind (-CR_{b1}R_{b2}-)ₙ (-SiR_{b1}R_{b2}-)ₙ, und -N-R_{b1}, P-R_{b1} bzw. 0, S, Se. Die Länge der Brücke n kann im Bereich 0 - 10, bevorzugt 0 und 1 liegen. Diese dient dazu, die Bindungsverhältnisse am Iridium koordinativ und damit energetisch günstig zu gestalten. Die Brückenreste können analog R_{x1-Xn}, R₁, R₂, R₃, aus obigen Listen ausgewählt werden.

Der Zyklus A ist bevorzugt aber nicht einschränkend wieder ein substituierter bzw. unsubstituierter Aromat aus der Reihe der in Tabelle 1 dargestellten Aromaten mit der Randbedingung, dass die Koordinationsstelle Y koordinativ mit dem Zentralatom Iridium wechselwirken kann. Y ist dabei bevorzugt nicht C im Sinne einer Zyklometallisierung, aber N, P, O oder S. Der Aromat ist dabei bevorzugt 5- oder 6-gliedrig. An diesen Aromaten können weitere Aromaten anneliert sein. Insbesondere im Falle N und P muss kein Ringssystem A angegliedert sein. Hier genügt die PR₁R₂ oder NR₁R₂ selbst.

Nach einer anderen Ausführungsform der Materialklasse sind R₁ und/oder R₂ mit anderen Resten R₁' und/oder R₂' eines weiteren Metallkomplexes verbunden. Die verbindende Gruppe kann dabei aus den unten genannten Beispielen entnommen werden. Falls höher funktionale Verbindungsglieder gewählt werden, hat man Zugang zu höher vernetzten Komplexen bis hin zu polymeren Komplexen. Auf der anderen Seite kann eine Brücke auch über einen der bekannten Liganden L zu einem oder mehreren weiteren Komplexen mit Liganden und Zentralatomen gebildet werden. Auch über diese Seite ist also ein Zugang zu oligomeren und polymeren Verbindungen möglich.

Y = C, meist in Zusammenhang mit n = 1 und X = (-CR_{b1}R_{b2}-), ist dann gegeben, wenn der Zyklus/Aromat A wiederum ein Carben ist. Für diesen Fall ergibt sich dabei folgende allgemeine Formel (Struktur II)

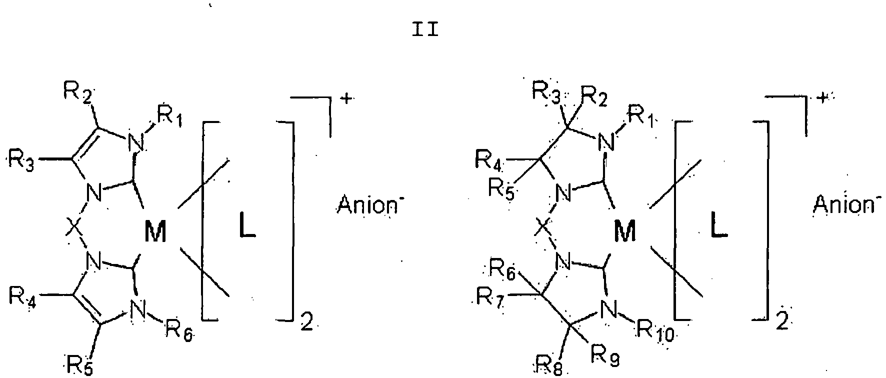

Struktur II: Allgemeine Formel für OLEEC-Emitter nach der Erfindung mit zwei Carbeneinheiten in einem zweizähnigen Liganden.

Für die Reste R₁ bis R₁₀ gelten die gleichen Bedingungen wie bei den in Struktur I dargestellten Strukturen, alle Substituenten R können unabhängig voneinander H, Methyl-, Ethyl-oder generell lineare oder verzweigt, kondensierte (Decahydronaphthyl-, Adamantyl-), cyclische (Cyclohexyl-) oder ganz oder teilweise substituierte Alkylreste (C1 - C20) sein. Die Alkylgruppen können funktionelle Gruppen wie Ether (Ethoxy-, Methoxy-, etc..), Ester-, Amid-, Carbonate etc. oder Halogene, bevorzugt F sein. R ist nicht auf Reste vom Alkyl-Typ beschränkt, sondern kann substituierte oder unsubstituierte aromatische Systeme, Heterocyclen, wie Phenyl, Biphenyl, Naphthyl, Phenanthryl etc. und Benzyl etc haben.

In Tabelle 1 wurden der Einfachheit halber nur die grundlegenden Strukturen gezeigt. Substitutionen können hier an jeder Position mit einer potentiellen Bindungsvalenz auftreten.

Ebenso gut kann der Rest R organometallischer Natur sein, beispielsweise Ferrocenyl- oder Phtalacyaninyl-.

Bevorzugt aber nicht einschränkend werden die Anionen ausgewählt aus: Fluorid, Chlorid, Bromid, Jodid, Sulfat, Phosphat, Carbonat, Trifluormethansulfonat, Trifluoracetat, Tosylat, Bis(trifluormethylsulfon)imid, Tetraphenylborat, B₉C₂H₁₁²; Hexafluorophosphat, Tetrafluoroborat, Hexafluoroantimonat.

Bevorzugt ist M = Iridium. Möglich sind aber auch Metalle, wie Re, Ru, Rh, Os, Pd, Au, Hg, Ag und Cu. Die Stöchiometrie der entsprechenden Komplexe wird dann je nach Koordinationssphäre des jeweiligen Zentralatoms variieren, insbesondere deshalb, weil nicht alle Metalle oktaedrische Komplexe wie das Iridium bilden.

Damit werden für den Fall M = Ir einfach positiv geladene ionische Übergangsmetallkomplexe erhalten (Kation). Die Ladung des Kations wird durch ein Anion kompensiert.

Nach einer anderen Ausführungsform der Materialklasse sind R₁ und/oder R₂ mit anderen Resten R₁' und/oder R₂' eines weiteren Metallkomplexes verbunden. Die verbindende Gruppe kann dabei aus den unten genannten Beispielen entnommen werden. Falls höher funktionale Verbindungsglieder gewählt werden, hat man Zugang zu höher vernetzten Komplexen bis hin zu Polymeren Komplexen. Auf der anderen Seite kann eine Brücke auch über einen der bekannten Liganden L zu einem oder mehreren weiteren Komplexen mit Liganden und Zentralatomen gebildet werden. Auch über diese Seite ist also ein Zugang zu oligomeren und polymeren Verbindungen möglich.

Die oben beschriebenen Materialien werden als Emittermaterial in lichtemittierenden elektrochemischen Zellen eingesetzt, genannt OLEEC (Organic Light Emitting Electrochemical Cell).

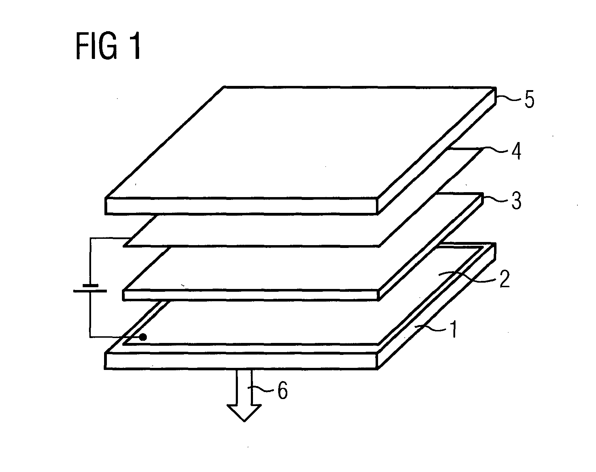

Figur 1 zeigt den Aufbau einer OLEEC schematisch.

Eine OLEEC 7 ist prinzipiell einfacher als die OLED aufgebaut und in den meisten Fällen durch ein einfaches Einbringen einer organischen Schicht 3 zwischen zwei Elektroden 2 und 4 und nachfolgender Verkapselung 5 realisierbar. Beim Anlegen von Spannung tritt Licht 6 aus. Die bevorzugt eine aktive emittierende Schicht 3 einer OLEEC besteht aus einer Matrix, in die eine emittierende Spezies eingebettet ist. Die Matrix kann aus einem Isolator oder aus einem Material bestehen, das entweder ein Ionenleiter mit Elektrolyt-Eigenschaften oder eine inerte Matrix (Isolator) ist. Die emittierende Spezies ist/sind ein oder mehrere ionische Übergangsmetallkomplexe (ionic transistion metal complexes, kurz: iTMC), wie beispielsweise Ruthenium-tris-bipyridin-hexafluorophosphate [Ru(bpy)₃]²⁺(PF₆⁻)₂ in polymerer Matrix.

Auf dem transparenten Substrat 1 befindet sich die untere Elektrodenschicht 2, beispielsweise die Anode. Darüber befinden sich die eigentlich aktive emittierende Schicht 3 und darüber die zweite Elektrode 4. Zur besseren Performance und Verarbeitung wird das Emittermaterial (iTMC), das die aktive Schicht 3 bildet, sprich die phosphoreszente Metallkomplexverbindung, gemeinsam mit einem Matrixmaterial in einem Lösemittel gelöst. Bevorzugt aber nicht einschränkend werden folgende Lösemittel eingesetzt: Acetonitril, Tetrahydrofuran (THF), Toluol, Ethylenglycoldiethylether, Butoxyethanol, Chlorbenzol, Propylenglycolmethyletheracetat, weitere organische und anorganische sowie polare oder unpolare und Lösungsmittelgemische sind auch im Sinne der Erfindung einsetzbar. Die löslichen Matrixmaterialien, die in Verbindung mit iTMCs eingesetzt werden, sind beispielsweise Polymere, Oligomere und ionische Flüssigkeiten.

Beispiele für polymere Matrixmaterialien (hohes Molekulargewicht) sind neben vielen anderen: Polycarbonat (PC), Polymethylmethacrylat (PMMA), Polyvinylcarbazol (PVK). Neben diesen "elektrisch isolierenden" Materialien können auch polymere Lochtransporter eingesetzt werden. Typische Vertreter sind: PEDOT (Poly-(3,4-ethylendioxythiophen), Poly(N,N'-bis,(4-butylphenyl)-N,N'-bis(phenyl)benzidine (PTPD), Polyaniline (PANI) und Poly(3-hexylthiophen(P3HT). Aus diesen Materialien können beliebige Co-polymere und/oder Block-co-polymere, die auch "isolierende", aber beispielsweise lösungsvermittelnde Einheiten enthalten können, eingesetzt werden. Beispiele dafür sind Polysytrol, ABS, Ethyleneinheiten, Vinyleinheiten etc.

Materialien mit niedrigem Molekulargewicht sog. Small Molecules können ebenfalls verwendet werden.

Im Folgenden werden verschiedene Beispiele für Lochtransporter-Materialien mit niedrigem Molekulargewicht aufgezählt:
N,N'-Bis(naphthalen-1-yl)-N,N'-bis(phenyl)-9,9-dimethyl-fluoren
N,N'-Bis(3-methylphenyl)-N,N'-bis(phenyl)-9,9-diphenyl-fluoren
N,N'-Bis(naphthalen-1-yl)-N,N'-bis(phenyl)-9,9-diphenyl-fluoren
N,N'-Bis(naphthalen-1-yl)-N,N'-bis(phenyl)-2,2-dimethylbenzidin
N, N'-Bis(3-methylphenyl)-N,N'-bis(phenyl)-9,9-spirobifluoren 2,2',7,7'-Tetrakis(N, N-diphenylamino)-9,9'-spirobifluoren
N, N'-Bis(naphthalen-1-yl)-N,N'-bis(phenyl)-benzidin
N, N'-Bis(naphthalen-2-yl)-N,N'-bis(phenyl)-benzidin
N, N'-Bis(3-methylphenyl)-N,N'-bis(phenyl)-benzidin
N,N'-Bis(3-methylphenyl)-N,N'-bis(phenyl)-9,9-dimethyl-fluoren
N,N'-Bis(naphthalen-1-yl)-N,N'-bis(phenyl)-9,9-spirobifluoren
Di-[4-(N,N-ditolyl-amino)-phenyl]cyclohexan
2,2',7,7'-tetra(N, N-di-tolyl)amino-spiro-bifluoren
9,9-Bis[4-(N,N-bis-biphenyl-4-yl-amino)phenyl]-9H-fluoren
2,2',7,7'-Tetrakis[N-naphthalenyl(phenyl)-amino]-9,9-spirobifluoren
2,7-Bis[N,N-bis(9,9-spiro-bifluorene-2-yl)-amino]-9,9-spirobifluoren
2,2'-Bis[N,N-bis(biphenyl-4-yl)amino]-9,9-spirobifluoren
N, N'-bis(phenanthren-9-yl)-N,N'-bis(phenyl)-benzidin
N, N,N',N'-tetra-naphthalen-2-yl-benzidin
2,2'-Bis(N,N-di-phenyl-amino)-9,9-spirobifluoren
9,9-Bis[4-(N,N-bis-naphthalen-2-yl-amino)phenyl]-9H-fluoren
9,9-Bis[4-(N, N'-bis-naphthalen-2-yl-N,N'-bis-phenyl-amino)-phenyl]-9H-fluoren
Titanium oxide phthalocyanin
Copper phthalocyanin
2,3,5,6-Tetrafluoro-7,7,8,8,-tetracyano-quinodimethan
4,4',4" -Tris(N-3-methylphenyl-N-phenyl-amino)triphenylamin
4,4',4" -Tris(N-(2-naphthyl)-N-phenyl-amino)triphenylamin
4,4',4" -Tris(N-(1-naphthyl)-N-phenyl-amino)triphenylamin
4,4',4" -Tris(N,N-diphenyl-amino)triphenylamin
Pyrazino[2,3-f][1,10]phenanthroline-2,3-dicarbonitril
N, N,N' ,N' -Tetrakis(4-methoxyphenyl)benzidin
2,7-Bis[N,N-bis(4-methoxy-phenyl)amino]-9,9-spirobifluoren
2,2'-Bis[N,N-bis(4-methoxy-phenyl)amino]-9,9-spirobifluoren
N, N'-di(naphthalen-2-yl)-N,N'-diphenylbenzene-1,4-diamin
N,N'-di-phenyl-N,N'-di-[4-(N,N-di-tolyl-amino)phenyl]benzidin
N,N'-di-phenyl-N,N'-di-[4-(N,N-di-phenyl-amino) phenyl] benzi din.

Nachfolgend ist eine Auswahl ionischer Flüssigkeiten aufgelistet, die ebenfalls in OLEEC-Bauteilen als Matrix Anwendung finden:
1-Benzyl-3-methylimidazolium hexafluorophosphate
1-Butyl-2,3-dimethylimidazolium hexafluorophosphate
1-Butyl-3-methylimidazolium hexafluorophosphate
1-Ethyl-3-methylimidazolium hexafluorophosphate
1-Hexyl-3-methylimidazolium hexafluorophosphate
1-Butyl-1-(3,3,4,4,5,5,6,6,7,7,8,8,8-tridecafluorooctyl)imidazolium hexafluorophosphate
1-Methyl-3-(3,3,4,4,5,5,6,6,7,7,8,8,8-tridecafluorooctyl)imidazolium hexafluorophosphate
1-Methyl-3-octylimidazolium hexafluorophosphate
1-Butyl-2,3-dimethylimidazolium tetrafluoroborate
1-Butyl-3-methylimidazolium tetrafluoroborate
1-Ethyl-3-methylimidazolium tetrafluoroborate
1-Hexyl-3-methylimidazolium tetrafluoroborate
1-Methyl-3-octylimidazolium tetrafluoroborate
1-Butyl-3-methylimidazolium trifluoromethanesulfonate
1-Ethyl-3-methylimidazolium trifluoromethanesulfonate
1,2,3-Trimethylimidazolium trifluoromethanesulfonate
1-Ethyl-3-methyl-imidazolium
bis(pentafluoroethylsulfonyl)imide
1-Butyl-3-methylimidazolium bis(trifluoromethylsulfonyl)imide
1-Butyl-3-methylimidazolium methanesulfonate
Tetrabutylammonium bis-trifluoromethanesulfonimidate
Tetrabutylammonium methanesulfonate
Tetrabutylammonium nonafluorobutanesulfonate
Tetrabutylammonium heptadecafluorooctanesulfonate
Tetrahexylammonium tetrafluoroborate
Tetrabutylammonium trifluoromethanesulfonate
Tetrabutylammonium benzoate
Tetrabutylammonium chloride
Tetrabutylammonium bromide
1-Benzyl-3-methylimidazolium tetrafluoroborate
Trihexyltetradecylphosphonium hexafluorophosphate
Tetrabutylphosphonium methanesulfonate
Tetrabutylphosphonium tetrafluoroborate
Tetrabutylphosphonium bromide
1-Butyl-3-methylpyridinium bis(trifluormethylsulfonyl)imide
1-Butyl-4-methylpyridinium hexafluorophosphate
1-Butyl-4-methylpyridinium tetrafluoroborate Sodium tetraphenylborate
Tetrabutylammonium tetraphenylborate
Sodium tetrakis(1-imidazolyl)borate
Cesium tetraphenylborate

Einige Beispiele zur Synthese der iTMC gemäß der Erfindung:

### Beispiel 1:

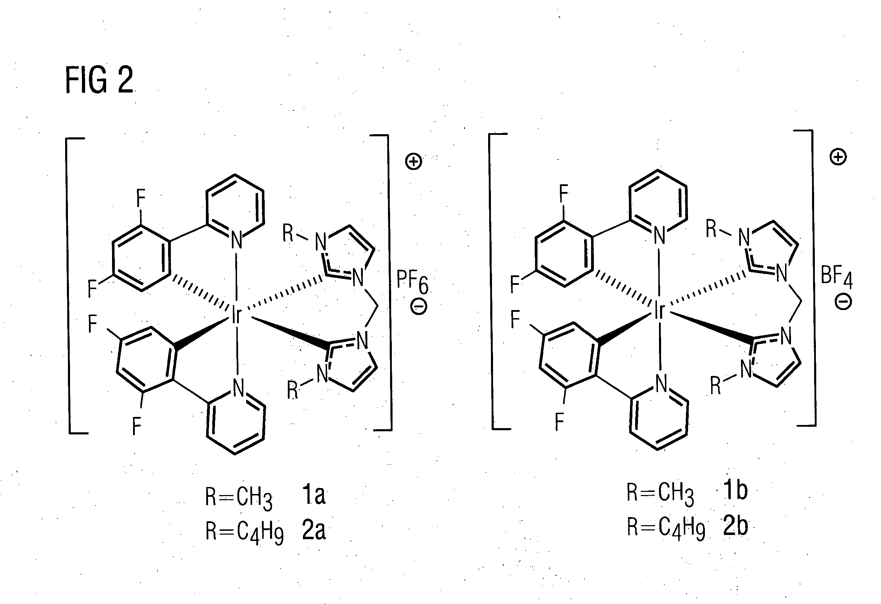

Die beiden in Figur 2 gezeigten kationischen blau emittierenden heteroleptischen Iridium 3+ basierten Metallkomplexe mit zwei Difluorophenyl pyridin sowie einem Methyl- (1a + 1b) oder n-butyl (2a + 2b) substituierten Bisimidazolium Salz wurden synthetisiert.

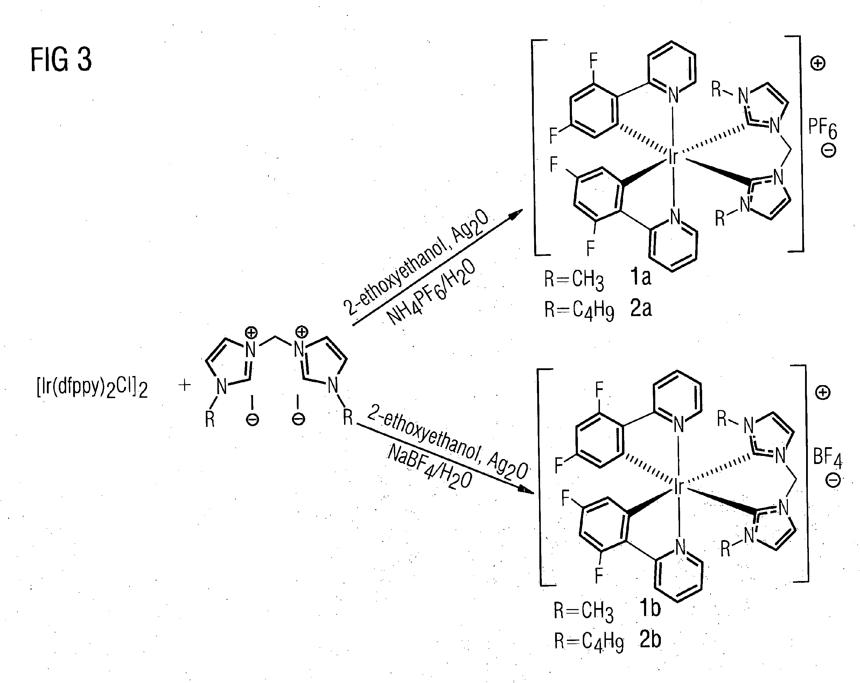

Figur 3 zeigt die Synthese und Charakterisierung kationischer blau-emittierender, heteroleptischer Ir(III) basierter Metallkomplexe mit zwei Difluorphenylpyridinliganden und einem Methyl (1a+b) oder n-Butyl (2a+b) substituierten bisimidazoliumsalzartigen Carbenliganden.

### Material Synthese (Fig. 3) :

Die Methyl und n-Butyl substituierten Bisimidazolium Salze (L1 und L2) wurden aus der Reaktion von 1-Methylimidazolium, 1-n-Butylmidazolium und Diiodomethan in THF gewonnen [1]. Der Iridium Komplex [(dfppy)₂Ir(µ-Cl)]₂ wurde aus IrCl₃·*n*H₂O und 4,6-Difluorphenyl Pyridin in 2-Ethoxyethanol gemäß Literatur [2] synthetisiert. Die Lösemittel wurden nach einer Standardprozedur getrocknet. Alle anderen Reagenzien wurden (wenn nicht explizit im Text angeben) ohne Veränderungen im Originalzustand des Herstellers verarbeitet.

### Synthese von '1'-Dimethyl-3,3'-Methylen-Diimidazolium Diio-did' (L1):

1-Methylimidazol (12 mmol, 1.0 g, 0.97 mL) und Diiodomethan (6 mmol, 1.61 g, 0.5 mL) wurden in 2ml Tetrahydrofuran in einem Druckrohrstutzen gelöst. Das Reaktionsgemisch wurde 1h bei 110°C gerührt bis sich eine weiße Ausfällung bildete. Der Feststoff wurde herausgefiltert und mit Tetrahydrofuran (5mL) und Toluol (5 mL) aufgereinigt. Anschließend wurde das Produkt im Vakuum getrocknet und als weißes Pulver (2.31 g, 5.2 mol 89 %) gewonnen.
Spektrum: 1H NMR (300 MHz, DMSO): δ 9.40 (s, 1H), 7.99 (t, J = 1.8, 1H), 7.81 (t, J = 1.8, 1H), 6.67 (s, 1H), 3.90 (s, 3H).

### Synthese von 1,1'-Di-n-Butyl-3,3'-Methylen-Diimidazolium Diiodid (L2):

1-n-Butylimidazol (7.6 mmol, 0.945 g, 1.0 mL) and Diiodomethan (3.8 mol, 1.013 g, 0.30 mL) wurden in 2 mL Tetrahydrofuran in einem geschlossenen Rohr gelöst. Das Reaktionsgemisch wurde für 3 h bei 110 °C gerührt bis sich eine weiße Ausfällung bildete. Der Feststoff wurde herausgefiltert und mit Tetrahydrofuran (5mL) und Toluol (5 mL) aufgereinigt. Anschließend wurde das Produkt im Vakuum getrocknet und als weißes Pulver 3.22 g, 6.2 mmol, 82 %) gewonnen.
Spektrum: 1H NMR (300 MHz, DMSO) δ 9.47 (s, 1H), 8.01 (t, J = 1.7, 1H), 7.92 (t, J = 1.8, 1H), 6.64 (s, 1H), 4.23 (t, J = 7.2, 2H), 2.00 - 1.66 (m, 2H), 1.29 (dq, J = 7.3, 14.6, 2H), 0.90 (t, J = 7.3, 3H).

### Synthese von Komplex 1a Bis[2-(4,6-Difluorphenyl)pyridinato-N,C2]Iridium(III)[1,1'-Dimethyl-3,3'-Methylen-diimidazolin-2,2'-Diyliden] Hexafluorophosphat:

Ein Gemisch aus 1,1'-Dimethyl-3,3'-Methylen-Diimidazolium Diiodid (0.036 g, 0.83 mmol), Ag₂O (0.04 g, 0.17 mmol) und einem Dichlor-gebrückten cyclometallisierten Iridium Komplex [(dfppy)₂Ir(µ-Cl)]2 (0.05 g, 0.04 mmol) in 2-Ethoxyethanol (10 mL) wurde unter Rückfluss in Dunkelheit für 12 Stunden erhitzt. Nach Abkühlung auf Raumtemperatur wurde die Lösung über eine Glasfritte gefiltert und (10 äquivalent) NH₄PF₆( in 20 mL H₂O) wurde zugeführt, um die Ausfällung einzuleiten.

Der gelbe Niederschlag wurde abgefiltert, mit H₂O gereinigt und unter Vakuum getrocknet. Der Feststoff wurde mittels Silica-Gel Säulenchromatographie (CH₂Cl₂ : MeCN = 9 : 1) gereinigt und als Endprodukt ergab sich ein gelblicher Komplex 1a (0.052 g, 0.058 mmol, 72 % Ausbeute).
Spektrum: 1H NMR (300 MHz, Aceton) :δ 8.55 (dd, J = 0.8, 5.9, 1H), 8.41 (d, J = 8.6, 1H), 8.10 (ddd, J = 0.5, 4.5, 8.3, 1H), 7.56 (d, J = 1.9, 1H), 7.30 (ddd, J = 1.4, 5.9, 7.3, 1H), 7.25 (d, J = 1.9, 1H), 6.58 (ddd, J = 2.4, 9.2, 12.9, 1H), 6.39 (s, 1H), 5.92 (dd, J = 2.4, 8.5, 1H), 3.01 (s, 3H). Hochauflösende Massenspektroskopie gefunden 749.1613 u ([M - PF₆]⁺). Elementaranalyse berechnet für C₃₁H₂₄F₁₀IrN₆P: C, 41.66; H, 2.71; N, 9.40. gefunden: C, 41.53; H, 2.84; N, 9.46 %..

### Synthese von Komplex 1b Bis[2-(4,6-Difluorphenyl)pyridinato-N,C2]Iridium(III)[1,1'-Dimethyl-3,3'-Methylen-Diimidazolin-2,2'-Diyliden] Tetrafluoroborat:

Ein Gemisch aus 1,1'-Dimethyl-3,3'-Methylen-Diimidazolium Diiodid (0.36 g, 8.3 mmol), Ag₂O (0.4 g, 1.7 mmol) und einem Dichlor-gebrückten cyclometallisierten Iridium Komplex [(dfppy)₂Ir(µ-Cl)]2 (0.5 g, 0.4 mmol) in 2-Ethoxyethanol (10 mL) wurde unter Rückfluss in Dunkelheit für 12 Stunden erhitzt.

Nach Abkühlung auf Raumtemperatur wurde die Lösung über eine Glasfritte gefiltert und (10 äquivalent) NH₄PF₆( in 20 mL H₂O) wurde zugeführt, um die Ausfällung einzuleiten. Der gelbe Niederschlag wurde herausgefiltert, mit H₂O gereinigt und unter Vakuumbedingungen getrocknet. Der Feststoff wurde mittels Silica-Gel Säulenchromatographie (CH₂Cl₂ : MeCN = 9 : 1) gereinigt und als Endprodukt ergab sich ein gelblicher Komplex 1b (0.46 g, 0.56 mmol, 68 % Ausbeute).
Spektrum: 1H NMR (300 MHz, Acetone) δ 8.60 - 8.51 (m, 1H), 8.46 - 8.35 (m, 1H), 8.16 - 8.03 (m, 1H), 7.58 (d, J = 2.0, 1H), 7.31 (ddd, J = 1.4, 5.9, 7.4, 1H), 7.23 (d, J = 2.0, 1H), 6.57 (ddd, J = 2.4, 9.2, 12.9, 1H), 6.38 (s, 1H), 5.92 (dd, J = 2.4, 8.5, 1H), 3.00 (s, 3H). Hochauflösende Massenspektroskopie gefunden 749.1635 u ([M - BF₄]⁺). Elementaranalyse berechnet für C₃₁H₂₄BF₈IrN₆: C, 44.56; H, 2.90; N, 10.06. gefunden: C, 44.09; H, 2.92; N, 9.84 %.

### Synthese von Komplex 2a Bis[2-(4,6-Difluorphenyl)pyridinato-N,C2]Iridium(III)[1,1'-Di-n-Butyl-3,3'-Methylen-Diimidazolin-2,2'-Diyliden] Hexafluorophosphat:

Ein Gemisch aus 1,1'-Dimethyl-3,3'-Methylen-Diimidazolium Diiodid (0.045 g, 0.087 mmol), Ag₂O (0.04 g, 0.17 mmol) und einem Dichlor-gebrückten cyclometallisierten Iridium Komplex [(dfppy)2Ir(µ-Cl)]2 (0.05 g, 0.04 mmol) in 2-Ethoxyethanol (10 mL) wurde unter Rückfluss in Dunkelheit für 12 Stunden erhitzt. Nach Abkühlung auf Raumtemperatur wurde die Lösung über eine Glasfritte gefiltert und (10 äquivalent) NH₄PF₆( in 20 mL H₂O) wurde zugeführt, um die Ausfällung einzuleiten.

Der gelbe Niederschlag wurde herausgefiltert, mit H₂O gereinigt und unter Vakuumbedingungen getrocknet. Der Feststoff wurde mittels Silica-Gel Säulenchromatographie (CH₂Cl₂ : MeCN = 9 : 1) abgetrennt und als Endprodukt ergab, sich ein gelblicher Komplex 2a (0.056 g, 0.057 mmol, 79 % Ausbeute).
Spektrum: 1H NMR (300 MHz, Acetone) δ 8.51 (dd, J = 0.8, 5.9, 1H), 8.48 - 8.40 (m, 1H), 8.11 (ddd, J = 0.9, 7.5, 8.3, 1H), 7.61 (d, J = 2.0, 1H), 7.39 - 7.29 (m, 2H), 6.60 (ddd, J = 2.4, 9.2, 12.9, 1H), 6.35 (s, 1H), 5.87 (dd, J = 2.4, 8.5, 1H), 3.59 - 3.33 (m, 2H), 1.29 - 1.09 (m, 1H), 0.94 - 0.74 (m, 2H), 0.65 (t, J = 7.2, 3H), 0.52 - 0.30 (m, 1H). Hochauflösende Massenspektroskopie gefunden 833.2576 u ([M - PF₆]⁺).
Elementaranalyse berechnet für C₃₇H₃₆F₁₀IrN₆P: C, 45.44; H, 3.71; N, 8.59. gefunden: C, 44.04; H, 3.62; N, 8.41 %.

### Synthese von Komplex 2b Bis[2-(4,6-Difluorphenyl)Pyridinato-N,C2]Iridium(III)[1,1'-Di-n-Butyl-3,3'-Methylen-Diimidazolin-2,2'-Diyliden] Tetrafluoroborat:

Ein Gemisch aus 1,1'-Dimethyl-3,3'-Methylen-Diimidazolium Diiodid (0.045 g, 0.087 mmol), Ag₂O (0.04 g, 0.17 mmol) und einem Dichlor-gebrückten cyclometallisierten Iridium Komplex [(dfppy)₂Ir(µ-Cl)]2 (0.05 g, 0.04 mmol) in 2-Ethoxyethanol (10 mL) wurde unter Rückfluss in Dunkelheit für 12 Stunden erhitzt. Nach Abkühlung auf Raumtemperatur wurde die Lösung über eine Glasfritte gefiltert und (10 äquivalent) NH₄PF₆( in 20 mL H₂O) wurde zugeführt, um die Ausfällung einzuleiten. Der gelbe Niederschlag wurde herausgefiltert, mit H₂O gereinigt und unter Vakuumbedingungen getrocknet. Der Feststoff wurde mittels Silica-Gel Säulenchromatographie (CH₂Cl₂ : MeCN = 9 : 1) gereinigt und als Endprodukt ergab sich ein gelblicher Komplex 2b (0.055 g, 0.059 mmol, 74 % Ausbeute). Spektrum: 1H NMR (300 MHz, Acetone) δ 8.52 (dd, J = 0.8, 5.9, 1H), 8.43 (d, J = 8.7, 1H), 8.11 (dd, J = 7.7, 8.5, 1H), 7.64 (d, J = 2.0, 1H), 7.39 - 7.26 (m, 2H), 6.60 (ddd, J = 2.4, 9.2, 12.9, 1H), 6.34 (s, 1H), 5.87 (dd, J = 2.4, 8.5, 1H), 3.58 - 3.35 (m, 2H), 1.19 (td, J = 5.8, 10.9, 1H), 0.96-0.72 (m, 2H), 0.65 (t, J = 7.2, 3H), 0.53 - 0.27 (m, 1H). Hochauflösende Massenspektroskopie gefunden 833.2558 u ([M-BF₄]⁺). Elementaranalyse berechnet für C₃₇H₃₆BF₈IrN₆: C, 48.32; H, 3.95; N, 9.14. gefunden: C, 48.01; H, 4.03; N, 9.05 %.

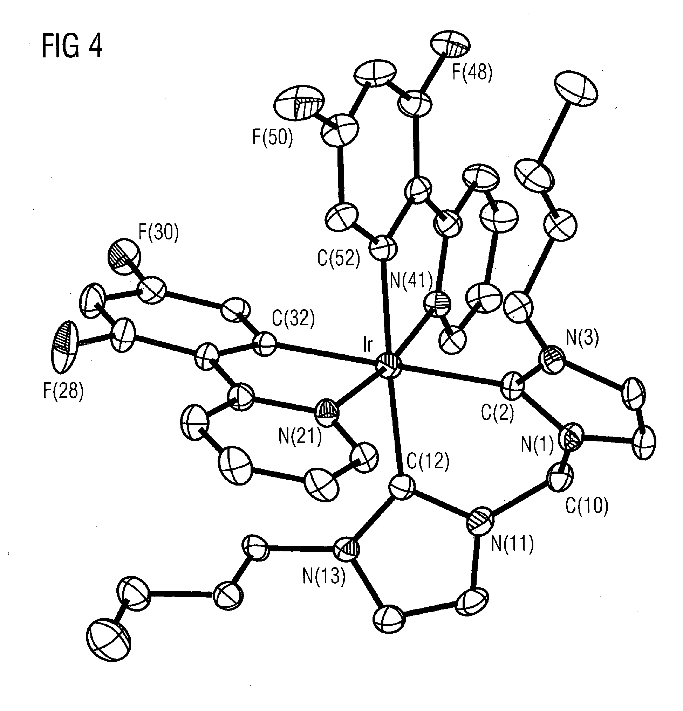

### X-Ray Charakterisierung (Figur 4)

Figur 4 zeigt das ORTEP Diagramm der Verbindung 2a mit thermischen Ellipsoiden in einem 30% Wahrscheinlichkeitsniveau. Zur besseren Übersichtlichkeit wurden die Acetonitril-Lösungsmittelmoleküle, die Gegenionen und die Wasserstoffatome weggelassen.

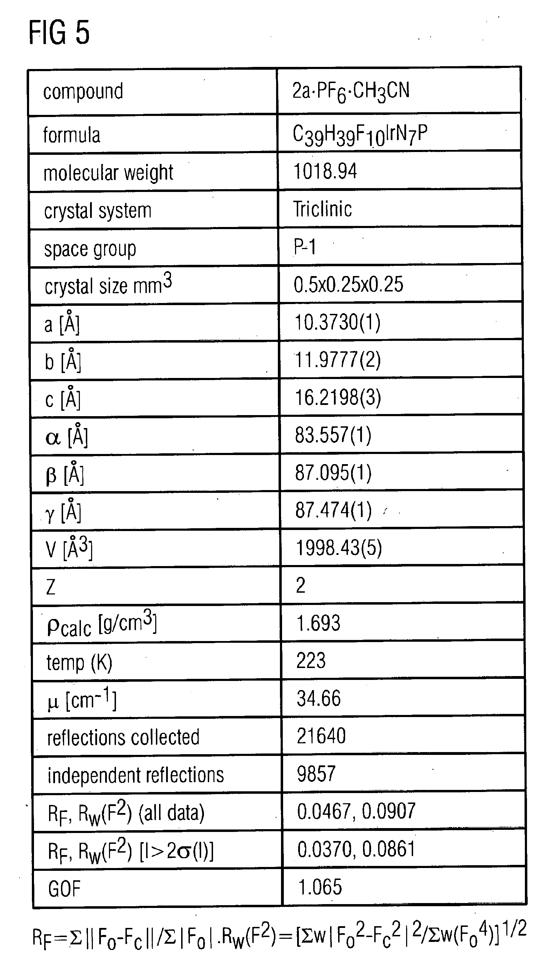

Figur 5 zeigt die dazugehörigen kristallographischen Daten.

Figur 6 zeigt ausgewählte Bindungslängen in Angström und Winkeln davon.

Figur 7 zeigt das Absorptionsspektrum in einer DCM-Lösung bei Raumtemperatur.

Figur 8 zeigt das Emissionsspektrum der Komplexe 1a, 1b, 2a und 2b bei 77K

Figur 9 zeigt das Emissionsspektrum der Komplexe in einem PMMA-Film in einer Konzentration von 5%

Figur 10 zeigt das Emissionsspektrum der Komplexe in einem NEAT Film

Figur 11 zeigt die photophysikalischen und elektrochemischen Daten der Komplexe

Figur 12 zeigt das cyclische Voltammogramm der Komplexe 2a, 2b (PF₆ und BF₄)

Figur 13 zeigt die Leuchtkraft als Funktion der Spannung bei OLEECs vom Carben-Typ.

Figur 14 zeigt die Stromdichten bei den OLEECs aus Figur 13

Figur 15 zeigt ihre Langzeitstabilität

Figur 16 zeigt das entsprechende Elektrolumineszenz-Spektrum

Um Kristallstrukturen des Komplexes 2a zu erhalten, die mittels Röntgenbeugungsmethoden (ORTEP-Diagramm) untersucht werden können, wurde Diethyl Ether in eine Acetonitril Lösung des Komplexes langsam eingedampft. Wie in Figur 4 dargestellt, zeichnet sich 2a durch eine verdrillte oktaedrische Geometrie um das Ir Atom mit cyclometallisierten dfppy Liganden und einem 1,1'-Di-n-Butyl-3,3'-Methylen-Diimidazol Liganden aus. Die dfppy Liganden nehmen eine zueinander gestaffelte Konfiguration ein, wo sich die Stickstoffatome N(21) und N(41) in einer Transposition mit den Abständen Ir-N(21) = 2.055(1) und Ir-N(41) = 2.072(1) Å befinden.

Die substituierten Phenylgruppen sind gegenseitig in Cis-Konfiguration ausgerichtet mit Abständen von Ir-C(32)= 2.054(1) and Ir-C(52) = 2.054(1) Å.

### Photophysikalische Charakterisierung

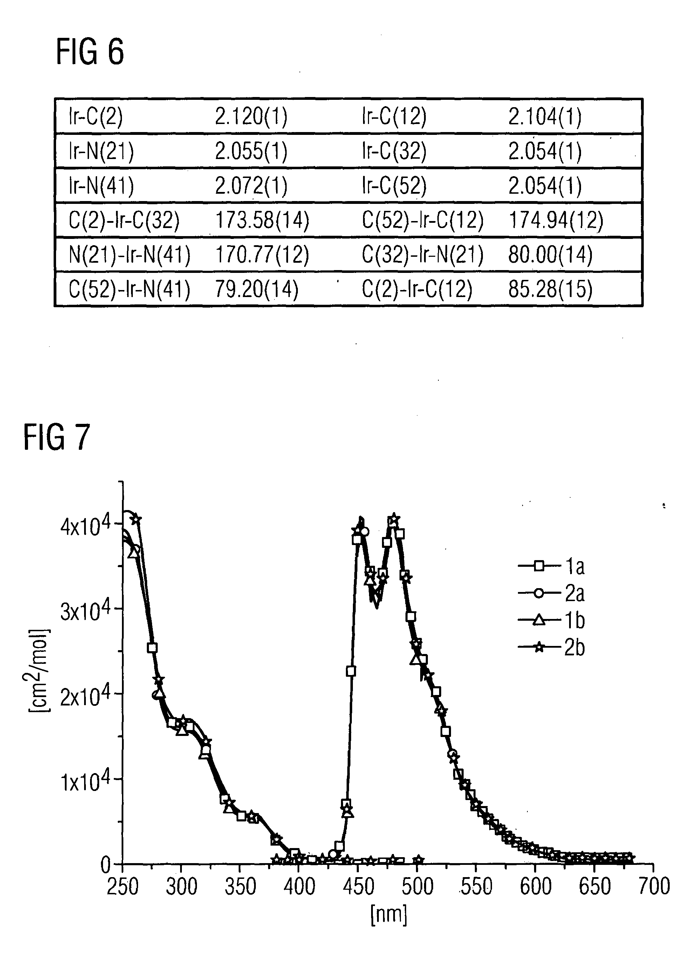

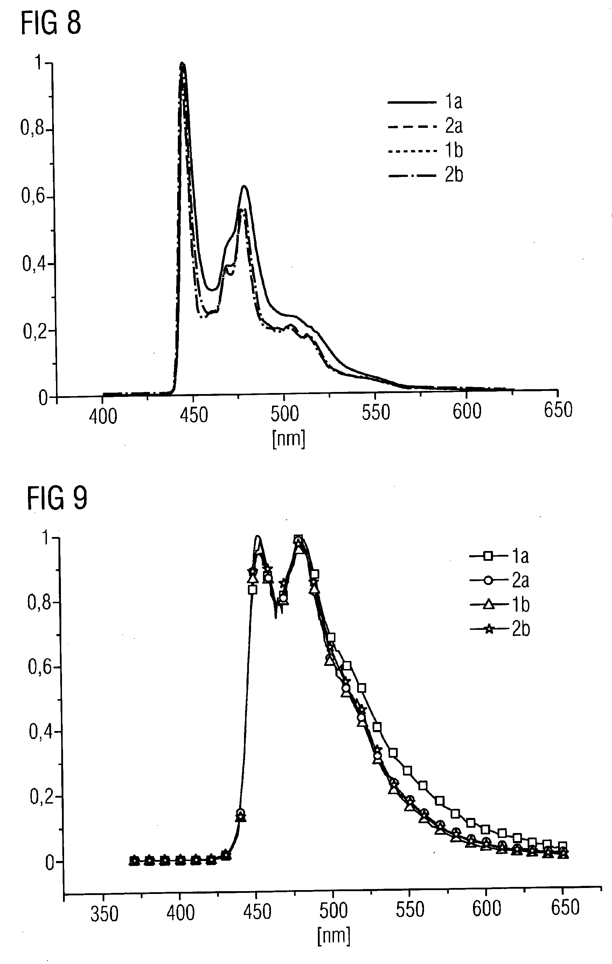

In Fig. 7 bis 10 sind UV/Vis Absorptions- und Emissionsspektren der Komplexe 1 ~2 gelöst in CH₂Cl₂ dargestellt.

Generell wird die dominierende Absorptionsbande für den Wellenlängenbereich ≤ 300 nm Spin erlaubten 1ππ* Übergängen der Liganden zugeordnet. Das strukturlose Band zwischen ~300 - 360 nm für 1 ~ 2 kann auf einen Überlapp des mit Fluor substituierten Phenyl-auf-Pyridin Inter-Ligand- ππ* Übergangs (engl LLCT: ligand ligand charge transfer) mit dem Ir(dπ) Metall auf Pyridyl Ligand Übergang (engl. MLCT: Metal ligand charge transfer zurückgeführt werden. Die Komplexe 1 -2 emittieren im blauen Wellenlängenbereich mit Peak-Wellenlängen bei ~452nm in entgaster CH₂Cl₂ Lösung. Das PL Spektrum der Komplexe weist keinen wesentlichen Unterschied auf. Alle Komplexe zeigen vibronisch strukturierte Emissionsspektren bei Raumtemperatur, was darauf hindeutet, dass die lichtemittierenden angeregten Zustände überwiegend einen ³LC ππ* neben ³MLCT oder 3LLCT Charakter aufweisen. Die Quantenausbeute Φ = 0.2 der Komplexe 1-2 wurde in einer Ulbrichtkugel in entgastem CH₂Cl₂ gemessen.

### Elektrochemische Charakterisierung

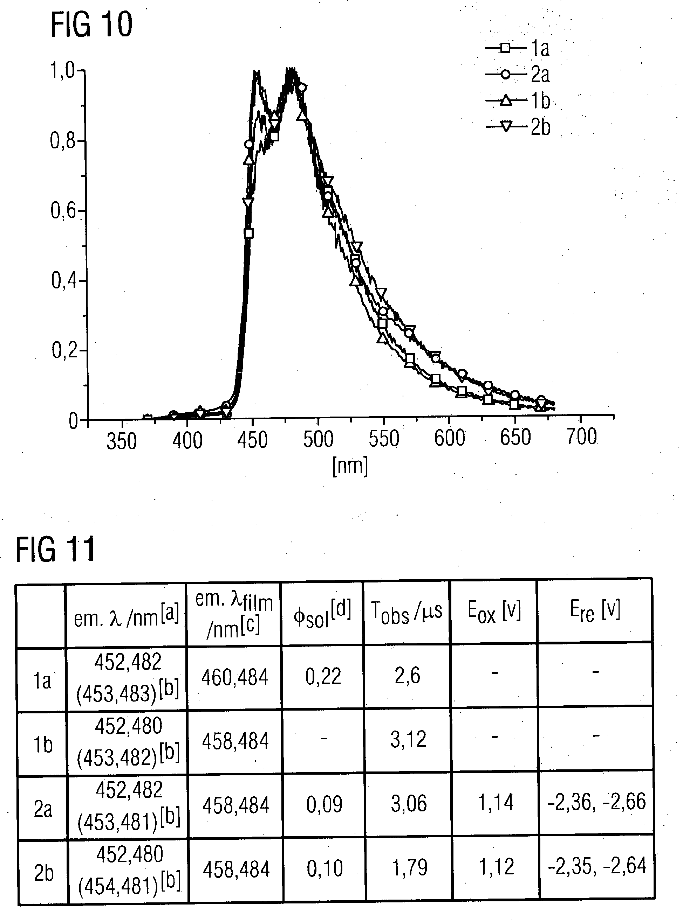

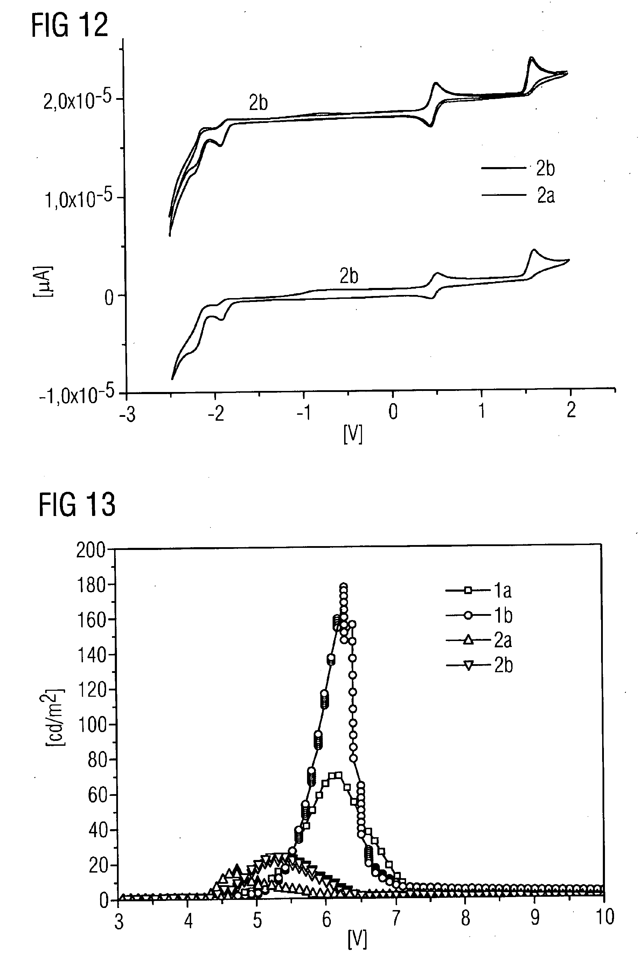

Das elektrochemische Verhalten dieser Ir Metal Komplexe wurde mittels Cyclovoltammetrie mit Ferrocen als internen Standard untersucht. Die Ergebnisse sind in Figur 11 aufgelistet. Wie in Figur 12 dargestellt weisen Komplex 2a und 2b quasireversible Oxidationsprozesse und irreversible Reduktionsprozesse in MeCN Lösung auf.

### Bauteilherstellung und Charakterisierung

Die aktive Fläche eines OLEEC Bauteils beträgt beispielsweise 4 mm². Die Bauteile wurden mittels Spincoat-Techniken auf Indium Zinn Oxid (ITO) Glassubstraten mit aufgedampften Al Kathoden hergestellt. Das Bauteil besteht aus 100nm poly(3,4-ethylenedioxythiophene):poly(styrenesulfonate) (PEDOT:PSS) und 70 nm des iTMC Komplexes mit Tetrabutylammonium Trifluormethansulfonat als Ionenleiter. PEDOT:PSS (Clevios AI4083) wurde hierbei von H.C. Starck und Tetrabutylammonium Trifluormethansulfonat von Sigma Aldrich bezogen. Die Emissionsschicht wurde folgendermaßen präpariert: 10mg des iTMC Komplexes wurde zusammen mit dem Ionenleiter in 1 ml Acetonitril in einem 1:1 Molverhältnis gelöst. Vor dem Spincoating wurde die Lösung mit einem 0.1µm PTFE-Filter gefiltert. Der nasse Film wurde für 2 Stunden bei 80°C in einem Vakuumofen getrocknet.

Schließlich wurde die Kathode bestehend aus 150-200nm Al aufgedampft und mit einer Glaskappe verkapselt, um Wechselwirkungen der organischen Schichten mit Luftmolekülen und Wasser zu unterbinden.

Um die elektrolumineszenten Eigenschaften der Bauteile zu untersuchen, wurden LIV Messungen (Spannung variabel) und Lebensdauermessungen (konstante Spannung) durchgeführt. Im Fall der LIV Messungen wurde die Stromdichte und die Leuchtdichte als Funktion der Spannung beginnend bei 0V (Zeit 0s) bis 10V in Schritten von 0.1V gemessen, wobei die Spannung alle 60s erhöht wurde. Bei den Lebensdauermessungen wurde die Spannung konstant auf 5.0V gesetzt und die Strom- und Leuchtdichte wurden alle 10s abgetastet. Alle elektrischen Charakterisierungen wurden mit einer E3646A Spannungsversorgung von Agilent Technologies durchgeführt. Die Lichtemission wurde mittels Photodioden registriert. Der Strom durch das Bauteil sowie der Photostrom wurden über Strommessgeräte NI9219 von National Instruments detektiert. Die Strombegrenzung wurde auf 40mV gesetzt. Mit Hilfe einer Spektralkamera (PR650) wurde der Photodiodenstrom kalibriert und das elektrolumineszente Spektrum im sichtbaren Wellenlängenbereich zwischen 380 und 780 nm detektiert.

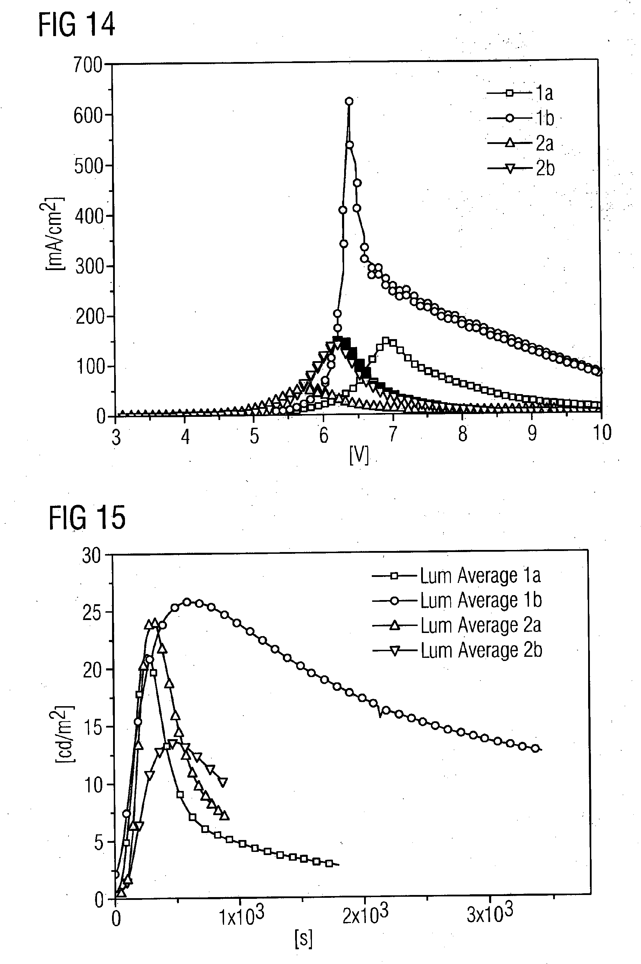

In Fig. 13 und 14 sind typische LIV Messungen der Komplexe 1a + b und 2a +b dargestellt. Für alle Bauteile wird eine peakförmige Charakteristik der Strom- und Leuchtdichte beobachtet, wobei die Bauteile bei Spannungen zwischen 4.0 und 5.0 V zu leuchten beginnt (Turn-on). Die Komplexe 1a und 1b weisen höhere Leuchtdichten (70 cd/m² bzw. 180 cd/m²) auf als die Komplexe 2a und 2b (beide ca. 20 cd/m²). Weiterhin ist der Einfluss der Gegenionen (vor allem für Komplex 1) signifikant: Es zeigt sich, dass die Leuchtdichten für Komplex 1b mit dem kleineren BF₄⁻ Ion (Lum≈180 cd/m²) höher ausfallen als für Komplex 1a mit dem größeren PF₆⁻ Ion (Lum≈70 cd/m²). Der beobachtete Abfall der Leuchtdichte für höhere Spannungen > 6.5 V kann auf Bauteilinstabilitäten bei höheren elektrischen Feldern zurückgeführt werden.

In Figur 15 sind zeitabhängige Messungen der Leuchtdichte der Carben basierten iTMCs abgebildet. Die dargestellten Charakteristiken wurden hierbei über sechs Bauteile gemittelt. Die besten Ergebnisse hinsichtlich Langzeitstabilität wurden hierbei für den Komplex 1b mit BF₄⁻ Gegenion erzielt. Die Turn-on Zeit (Zeit bis zum Erreichen der maximalen Leuchtdichte) variiert hierbei zwischen 260s (1a) und 620s (1b).

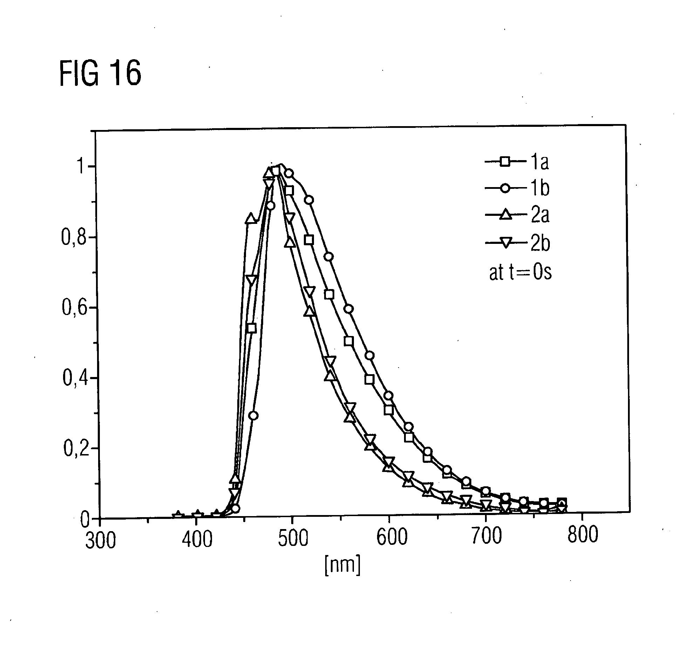

In Figur 16 ist das Emissionsspektrum für eine angelegte Spannung von 5.5V gezeigt. Vor allem die iTMC Komplexe 2a und 2b emittieren im blau-grünen Wellenlängenbereich mit einem lokalen Maximum bei 456nm und 488nm.

## Patentansprüche

1. Lichtemittierende organische elektrochemische Zelle umfassend
- ein Substrat,
- eine erste Elektrodenschicht auf dem Substrat,
- zumindest eine organische emittierende Schicht auf der ersten Elektrodenschicht und
eine zweite Elektrodenschicht auf der organischen emittierenden Schicht, wobei die organische emittierende Schicht aus einer Matrix, die ein Isolator oder ein Ionenleiter mit Elektrolyt-Eigenschaften ist und einer phosphoreszenten Metallkomplexverbindung besteht, wobei die Metallkomplexverbindung zumindest ein metallisches Zentralatom M und zumindest einen durch das metallische Zentralatom koordinierten Liganden umfasst, wobei der eine Ligand zweizähnig ist, zwei neutrale Koordinationsstellen hat und zumindest eine Carbeneinheit, die direkt an das Metallatom koordiniert ist, umfasst, wobei die Verbindung zumindest eine der Strukturformeln 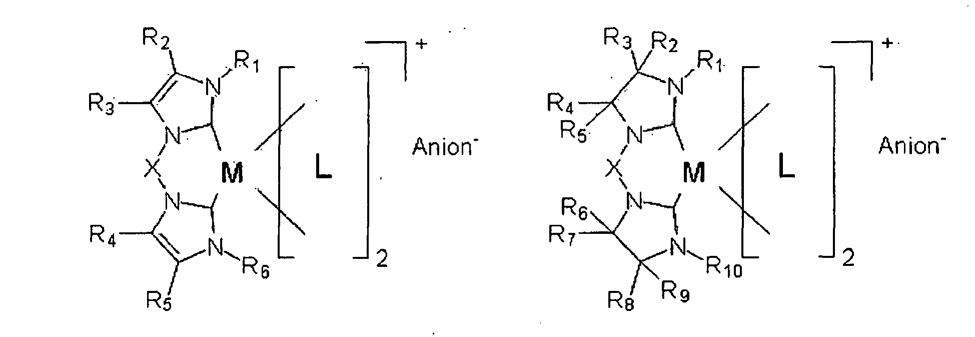 aufweist, wobei gilt:
- M = Ir, Re, Os, Au, Hg, Ru, Rh, Pd, Ag, Cu
- R₁ bis R₁₀ sind unabhängig voneinander - H, verzweigte Alkylreste, unverzweigte Alkylreste, kondensierte Alkylreste, ringförmige Alkylreste, vollständig oder teilweise substituierte unverzweigte Alkylreste, vollständig oder teilweise substituierte verzweigte Alkylreste, vollständig oder teilweise substituierte kondensierte Alkylreste, vollständig oder teilweise substituierte ringförmige Alkylreste, Alkoxygruppen, Amine, Amide, Ester, Carbonate, Aromaten, vollständig oder teilweise substituierte Aromaten, Heteroaromaten, kondensierte Aromaten, vollständig oder teilweise substituierte kondensierte Aromaten, Heterocyclen, vollständig oder teilweise substituierte Heterocyclen, kondensierte Heterocyclen, Halogene, Pseudohalogene,
- X ist (-CR_{b1}R_{b2}-)ₙ, (-SiR_{b1}R_{b2}-)ₙ, -N-R_{b1}, P-R_{b1} oder 0, S, Se, wobei n im Bereich 0 - 10 liegt, wobei R_{b1} und R_{b2} analog R₁ bis R₁₀ ausgewählt sind,
- L ist über eine N^C Einheit an das Zentralatom M gebunden und ausgewählt aus einer Gruppe, die 2-Phenylpyridin, 2-Phenylimidazol, Benzimidazol, Phenanthridin und 2-(2,4-Difluorophenyl)pyridin umfasst
und wobei R₁ und/oder R₆ zusätzlich an M koordiniert sind.

2. Elektrochemische Zelle nach Anspruch 1, wobei die Metallkomplexverbindung mehrkernig ist und zumindest zwei metallische Zentralatome M aufweist.

3. Elektrochemische Zelle nach dem vorherigen Anspruch, wobei die zumindest zwei metallischen Zentralatome M über eine Metall-Metall-Wechselwirkung aneinander koordiniert sind.

4. Elektrochemische Zelle nach einem der vorherigen Ansprüche 2 oder 3, wobei die zumindest zwei metallischen Zentralatome M über zumindest einen zusätzlichen Brückenliganden verbunden sind.

5. Elektrochemische Zelle nach dem vorhergehenden Anspruch, wobei die phosphoreszente Metallverbindung in dem Matrixmaterial eingebettet ist.

6. Elektrochemische Zelle nach einem der vorhergehenden Ansprüche, die bei Anlegen einer Spannung Licht einer Farbe emittiert, die ausgewählt ist aus einer Gruppe umfassend die Farben grün, blau-grün, hellblau, tiefblau, blau.

7. Elektrochemische Zelle nach einem der vorhergehenden Ansprüche, wobei das Substrat und die erste Elektrodenschicht transparent sind.

8. Elektrochemische Zelle nach einem der vorhergehenden Ansprüche, wobei das Substrat und die erste und die zweite Elektrodenschicht transparent sind.

## Claims

1. Light-emitting organic electrochemical cell comprising
- a substrate,
- a first electrode layer on the substrate,
- at least one organic emitting layer on the first electrode layer and
a second electrode layer on the organic emitting layer, wherein the organic emitting layer consists of a matrix which is an insulator or an ion conductor having electrolyte properties and of a phosphorescent metal complex, wherein the metal complex comprises at least one metallic central atom M and at least one ligand coordinated by the metallic central atom, wherein one ligand is bidentate, has two uncharged coordination sites and comprises at least one carbene unit coordinated directly to the metal atom, wherein the complex has at least one of the structural formulae 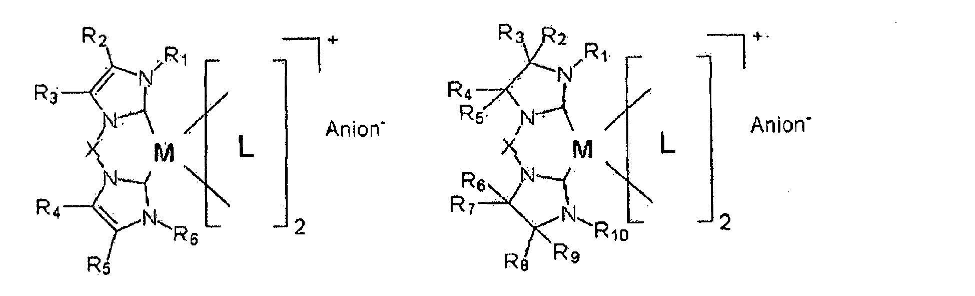 where:
- M = Ir, Re, Os, Au, Hg, Ru, Rh, Pd, Ag, Cu
- R₁ to R₁₀ are independently H, branched alkyl radicals, unbranched alkyl radicals, fused alkyl radicals, cyclic alkyl radicals, fully or partly substituted unbranched alkyl radicals, fully or partly substituted branched alkyl radicals, fully or partly substituted fused alkyl radicals, fully or partly substituted cyclic alkyl radicals, alkoxy groups, amines, amides, esters, carbonates, aromatics, fully or partly substituted aromatics, heteroaromatics, fused aromatics, fully or partly substituted fused aromatics, heterocycles, fully or partly substituted heterocycles, fused heterocycles, halogens, pseudohalogens,
- X is (-CR_{b1}R_{b2}-)ₙ, (-SiR_{b1}R_{b2}-)ₙ, -N-R_{b1}, -P-R_{b1}, or O, S, Se, where n is in the range of 0-10, where R_{b1} and R_{b2} are selected analogously to R₁ to R₁₀,
- L is bonded to the central atom M via an N^C unit and is selected from a group comprising 2-phenylpyridine, 2-phenylimidazole, benzimidazole, phenanthridine and 2-(2,4-difluorophenyl)pyridine, and wherein R₁ and/or R₆ is additionally coordinated to M.

2. Electrochemical cell according to Claim 1, wherein the metal complex is polynuclear and has at least two metallic central atoms M.

3. Electrochemical cell according to the preceding claim, wherein the at least two metallic central atoms M are coordinated to one another via a metal-metal interaction.

4. Electrochemical cell according to either of the preceding Claims 2 and 3, wherein the at least two metallic central atoms M are joined via at least one additional bridge ligand.

5. Electrochemical cell according to the preceding claim, wherein the phosphorescent metal compound is embedded in the matrix material.

6. Electrochemical cell according to any of the preceding claims, which on application of a voltage emits light of a color selected from a group comprising the colors of green, blue green, light blue, deep blue, blue.

7. Electrochemical cell according to any of the preceding claims, wherein the substrate and the first electrode layer are transparent.

8. Electrochemical cell according to any of the preceding claims, wherein the substrate and the first and second electrode layers are transparent.

## Revendications

1. Cellule électrochimique organique émettrice de lumière comprenant
- un substrat,
- une première couche d'électrodes sur le substrat,
- au moins une couche émettrice organique sur la première couche d'électrodes et
une seconde couche d'électrodes sur la couche émettrice organique, dans laquelle la couche émettrice organique est constituée d'une matrice qui est un isolant ou un conducteur ionique ayant des propriétés d'électrolyte et d'un composé complexe métallique, dans lequel le composé complexe métallique comprend au moins un atome central métallique M et au moins un ligand coordonné par l'atome central métallique, dans lequel ledit ligand est bidenté, comporte deux sites de coordination neutres et comprend au moins un motif carbène qui est directement coordonné à l'atome de métal, dans lequel le composé présente au moins l'une des formules de structure suivantes 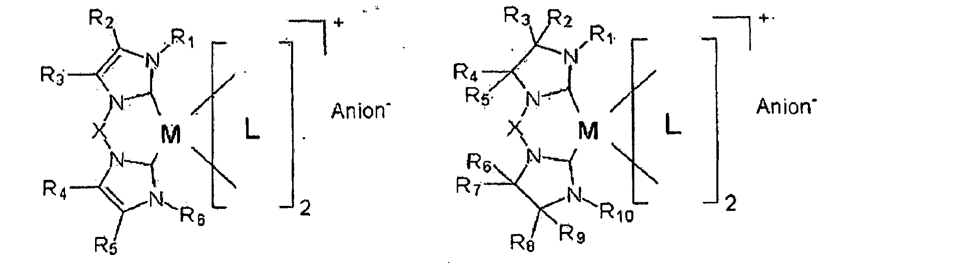 dans lequel :
- M = Ir, Re, Os, Au, Hg, Ru, Rh, Pd, Ag, Cu
- R₁ à R₁₀ sont indépendamment l'un de l'autre - H, des radicaux alkyle ramifiés, des radicaux alkyle non ramifiés, des radicaux alkyle condensés, des radicaux alkyle cycliques, des radicaux alkyle non ramifiés entièrement ou partiellement substitués, des radicaux alkyle ramifiés entièrement ou partiellement substitués, des radicaux alkyle condensés entièrement ou partiellement substitués, des radicaux alkyle cycliques entièrement ou partiellement substitués, des groupes alcoxy, des amines, des amides, des esters, des carbonates, des composés aromatiques, des composés aromatiques entièrement ou partiellement substitués, des composés hétéro-aromatiques, des composés aromatiques condensés, des composés aromatiques condensés entièrement ou partiellement substitués, des hétérocycles, des hétérocycles entièrement ou partiellement substituées, d'hétérocycles condensés, des halogènes, des pseudo-halogènes,
- X est (-CR_{b1}R_{b2}-)ₙ, (-SiR_{b1}R_{b2}-)ₙ, -N-R_{b1}, P-R_{b1} ou O, S, Se, où n se situe dans l'intervalle 0 - 10, dans lequel R_{b1} et R_{b2} sont sélectionnés de manière analogue à R₁ à R₁₀,
- L est lié par l'intermédiaire d'un motif N^C à l'atome central M et est sélectionné dans le groupe constitué de la 2-phénylpyridine, du 2-phénylimidazole, du benzimidazole, de la phénanthridine et de la 2-(2,4-difluorophényl)pyridine et dans lequel R₁ et/ou R₆ sont en outre coordonnés à M.

2. Cellule électrochimique selon la revendication 1, dans lequel le composé complexe métallique est polynucléaire et comporte au moins deux atomes centraux métalliques M.

3. Cellule électrochimique selon l'une quelconque des revendications précédentes, dans lequel les au moins deux atomes centraux métalliques M sont coordonnés l'un à l'autre par l'intermédiaire d'une interaction métal-métal.

4. Cellule électrochimique selon l'une quelconque des revendications 2 ou 3 précédentes, dans lequel les au moins deux atomes centraux métalliques M sont liés par l'intermédiaire d'au moins un ligand de pontage.

5. Cellule électrochimique selon l'une quelconque des revendications précédentes, dans lequel le composé métallique phosphorescent est incorporé au matériau de matrice.

6. Cellule électrochimique selon l'une quelconque des revendications précédentes, émettant, lorsqu'une tension lui est appliquée, une lumière dont la couleur est sélectionnée dans le groupe comprenant les couleurs verte, bleu-vert, bleu clair, bleu foncé, bleu.

7. Cellule électrochimique selon l'une quelconque des revendications précédentes, dans lequel le substrat et la première couche d'électrodes sont transparents.

8. Cellule électrochimique selon l'une quelconque des revendications précédentes, dans lequel le substrat et les première et seconde couches d'électrodes sont transparents.
